# EUROPÄISCHE PATENTANMELDUNG

(11) **EP 0 996 325 A2**
(43) Veröffentlichungstag der Anmeldung: **26.04.2000**
(21) Anmeldenummer: 99114564.0
(22) Anmeldetag: 24.07.1999
(51) Int. Cl.: H05K 13/00

(54) **Ofen und ein Verfahren zum Erwärmen eines mit elektronischen Bauelementen versehenen Trägerelements**

(30) Priorität: 25.08.1998 DE 19838482
(71) Anmelder: Orga Kartensysteme GmbH, 33104 Paderborn (DE)
(72) Erfinder: Brauer, Werner, 25563 Wrist (DE)

(57) **Zusammenfassung**

Die Erfindung betrifft einen Ofen und ein Verfahren zum Erwärmen eines mit elektronischen Bauelementen versehenen Trägerelements mit einem Gehäuse mit einer Eingangsöffnung und einer Ausgangsöffnung für die auf einem vorgegebenen Weg geführten Chipträger und mit Mitteln zum Heizen zur Erzeugung einer vorgegebenen Heiztemperatur innerhalb des Gehäuses, wobei ein oberes Gehäuseteil (2) und ein unteres Gehäuseteil (3) vorgesehen sind, die jeweils aus einem wärmeleitenden Material bestehen, die Gehäuseteile (2, 3) jeweils eine Mehrzahl von Öffnungen (13) aufweisen, in denen die Mittel zum Heizen (14) einsteckbar sind, mindestens ein Gehäuseteil (2) in Querrichtung verschiebbar gelagert ist und ein Fördermittel (10) vorgesehen ist zum Transport der Chipträger (18) von der Eingangsöffnung (16) zu der Ausgangsöffnung (17).

## Beschreibung

Die Erfindung betrifft einen Ofen nach dem Oberbegriff des Anspruchs 1 sowie ein Verfahren zum Erwärmen eines mit elektronischen Bauelementen versehenen Trägerelements nach dem Oberbegriff des Patentanspruchs 16.

Aus der US 5 647 740 A1 ist ein Ofen zum Erwärmen von Leiterplatten bekannt, in dem die bestückten Leiterplatten einzeln durch eine Eingangsöffnung in das Gehäuse des Ofens verbracht und dort aufeinander gestapelt werden, bevor sie durch eine Ausgangsöffnung den Ofen verlassen. Nachteilig an dem bekannten Ofen ist, daß die Erwärmung der Leiterplatten durch Luft erzeugt wird, die mittels einer Gebläseeinrichtung zu den zu erwärmenden Leiterplatten gefördert werden muß.

Aufgabe der Erfindung ist es daher, einen Ofen und ein Verfahren zum Erwärmen eines mit elektronischen Bauelementen versehenen Trägerelements derart weiterzubilden, daß eine zuverlässige und homogene Erwärmung der zu erwärmenden Bauelemente gewährleistet ist.

Zur Lösung dieser Aufgabe weist die Erfindung die Merkmale des Patentanspruchs 1 bzw. des Patentanspruchs 16 auf.

Der besondere Vorteil der Erfindung ist darin zu sehen, daß durch die erwärmten und in unmittelbarer Nähe zu den zu erwärmenden Bauteilen angeordneten Gehäuseteile des Ofens eine kontinuierliche und homogene Erwärmung des Trägerelements bzw. der auf diesen angeordneten Bauelemente erfolgen kann.

Nach einer bevorzugten Ausführungsform der Erfindung sind die Gehäuseteile jeweils langgestreckt ausgebildet und weisen jeweils in Querrichtung verlaufende Bohrungen zur Aufnahme von Heizelementen, vorzugsweise Heizpatronen, auf. Der Abstand der Bohrungen zueinander ist auf die Heizungsleistung der Heizpatronen abgestimmt. Dadurch, daß die Heizpatronen zumindest entlang der Mantelfläche vollständig durch das wärmeleitende Material des Gehäuseteils umgeben ist, kann eine gleichmäßige Wärmeabgabe entlang der dem Trägerelement zugewandten Heizfläche des Gehäuseteils verwirklicht werden.

Nach einer Weiterbildung der Erfindung weist mindestens ein Gehäuseteil eine sich in Längsrichtung erstreckende rinnenförmige Ausnehmung auf zur Aufnahme des durch ein Fördermittel transportierten Trägerelements. Diese Ausnehmung erstreckt sich stufenförmig in einem mittleren Bereich einer breiten Längsseite des Gehäuseteils. Durch die hierbei gebildeten Seitenabschnitte der Ausnehmung erfolgt eine Wärmeabgabe in seitlicher Richtung, so daß die linear bewegten Trägerelement geschlossen entlang des Umfangs erwärmt werden.

Nach einer Weiterbildung der Erfindung weist das Gehäuseteil entlang eines an den mittleren Bereich angrenzenden äußeren Bereichs planflächige Seitenabschnitte auf, die unmittelbar an korrespondierenden Seitenabschnitten des benachbarten Gehäuseabschnitts anliegen, die eine seitliche Wärmeabgabe an den Trägerelement förderlich sind.

Nach einer Weiterbildung der Erfindung wird der Trägerelement auf einem kontinuierlich bewegbaren Förderband durch den Ofen transportiert, wobei die jeweils einteiligen Gehäuseteile durch in Längsrichtung eingebrachte Heizelemente unterschiedlicher Heizleistung eine in Längsrichtung gewünschte Temperaturverteilung erzeugen. Hierdurch können unterschiedliche Temperaturzonen erzeugt werden, wobei der Übergang zwischen den Temperaturzonen stetig ist.

Nach einer Ausgestaltung der Erfindung ist mindestens ein Gehäuseteil in Querrichtung verschiebbar gelagert, so daß bei Stillstand des Förderbandes eine Zerstörung durch überhöhte Erwärmung des auf dem Trägerelement angeordneten Bauelements vermieden werden kann.

Weitere Vorteile der Erfindung ergeben sich aus den weiteren Unteransprüchen.

Ein Ausführungsbeispiel ist nachfolgend anhand der Zeichnungen näher erläutert.

Es zeigen:
- Figur 1:: eine Seitenansicht eines Ofens,

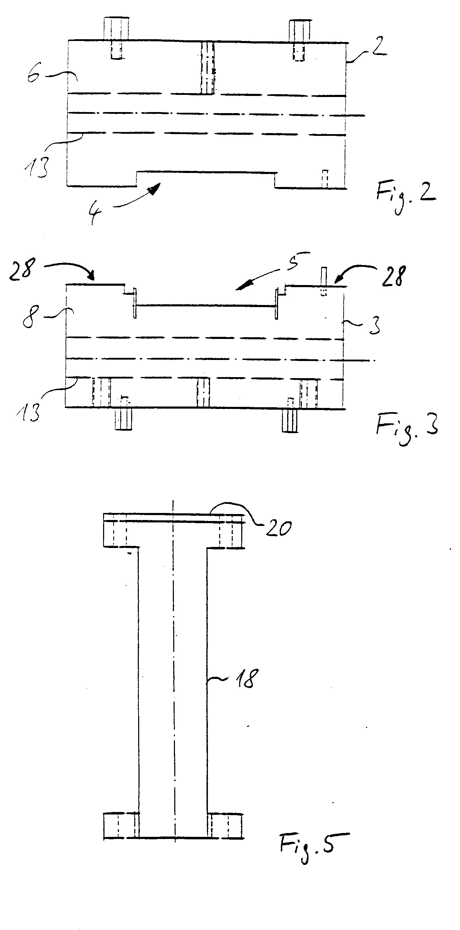

- Figur 2:: eine Stirnansicht eines oberen Gehäuseteils,
- Figur 3:: eine Stirnansicht eines unteren Gehäuseteils,
- Figur 4:: eine Seitenansicht eines Förderbandes,
- Figur 5:: eine Seitenansicht eines Trägers des Ofens und
- Figur 6:: eine schematische Stirnansicht des oberen Gehäuseteils und einer Abdeckung.

Der erfindungsgemäße Ofen kann zur Erwärmung eines Trägerelements bzw. einer Leiterplatte oder, wie im folgenden beschrieben, zum Aushärten von einer auf einen mit einem Chip versehenen Chipträger 27 aufgebrachten Abdeckmasse eingesetzt werden. Diese Abdeckmasse dient zum Schutz eines mittels Bondtechnik auf einen Chipträger aufgebrachten Chips. Dieser Chip wird dann in eine Ausnehmung eines kreditkartengroßen Kartenkörpers zur Bildung einer Chipkarte eingebettet.

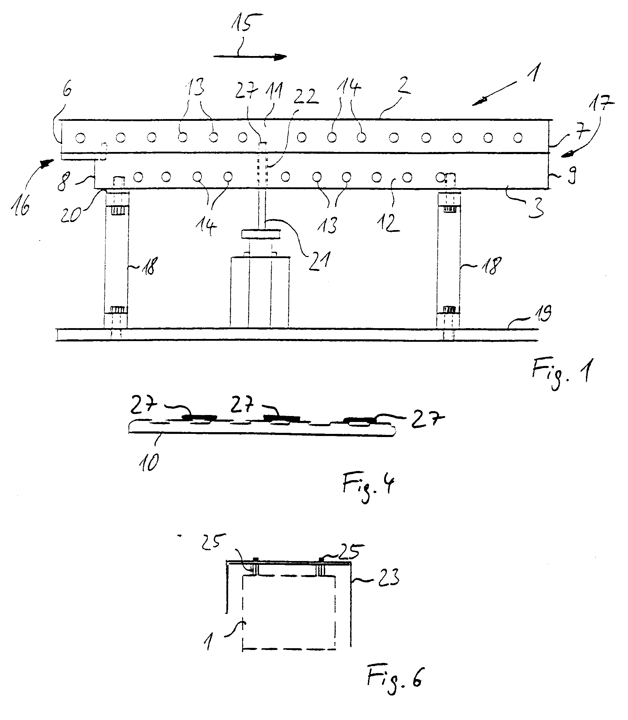

Figur 1 zeigt einen Ofen 1, der im wesentlichen aus einem oberen Gehäuseteil 2 und einem unteren Gehäuseteil 3 besteht.

Das obere Gehäuseteil 2 und das untere Gehäuseteil 3 weisen jeweils in einem mittleren Bereich eine Ausnehmung 4 und 5 auf. Die Ausnehmung 4 ist im Querschnitt rechteckförmig ausgebildet und erstreckt sich von einer ersten Stirnseite 6 des oberen Gehäuseteils 2 zu einer gegenüberliegenden zweiten Stirnseite 7 desselben. Die Ausnehmung 5 ist im Querschnitt stufenförmig ausgebildet und erstreckt sich von einer ersten Stirnseite 8 des unteren Gehäuseteile 3 zu einer gegenüberliegenden Stirnseite 9. Die Ausnehmungen 4, 5 bilden einen Heizspalt für den Transport der jeweils mit elektronischen Bauelementen versehenen Trägerelement durch den Ofen 1.

Zusätzlich bildet die untere Ausnehmung 5 eine Aufnahme für ein Endlos-Förderband 10, auf dem der mit jeweils elektronischen Bauelementen versehene Chipträger 27 durch den Ofen 1 transportiert wird. Zu diesem Zweck weist die Ausnehmung 5 einen schulterförmigen Querschnitt mit randseitig angeordneten kurzen Schultern auf.

In einem an den mittleren sich anschließenden äußeren Bereich 28 sind die Gehäuseteile 2, 3 eben ausgebildet, so daß sie mittels geeigneter Befestigungsmittel in der Betriebsposition formschlüssig unmittelbar flächig aneinanderliegen.

Die Gehäuseteile 2 und 3 weisen jeweils entlang ihrer Seitenwände 11 und 12 eine Vielzahl von Bohrungen 13 auf, in denen jeweils ein Mittel zum Heizen 14 angeordnet ist. Das Mittel zum Heizen 14 ist als Heizpatrone ausgebildet. Die Bohrungen 13 sind jeweils quer zu einer Transportrichtung 15 ausgerichtet. Der Abstand der Bohrungen 13 zueinander ist derart gewählt, daß eine gleichmäßige Erwärmung des oberen Gehäuseteils 2 einerseits und des unteren Gehäuseteils 3 andererseits gewährleistet ist.

In einer Betriebsstellung gemäß Figur 1 liegen das obere und untere Gehäuseteil 2 und 3 flächig aneinander, wobei die durchgängigen Ausnehmungen 4, 5 eine Eingangsöffnung 16 auf der ersten Stirnseite 6, 8 der Gehäuseteile 2, 3 einerseits und eine Ausgangsöffnung 17 auf der zweiten Stirnseite 7, 9 der Gehäuseteile 2, 3 andererseits bilden. Durch die Heizpatronen 14 werden die Gehäuseteile 2, 3 gleichmäßig auf eine vorgegebene Temperatur erwärmt, so daß das Fördergut (Trägerelement mit Bauelement) mittels Wärmestrahlung von oben und unten sowie von der Seite erwärmt wird.

Das untere Gehäuseteil 3 ist mittels kraftschlüssig verbundener Träger 18 von einem Boden 19 beabstandet angeordnet. Der Träger 18 ist doppel-T-förmig ausgebildet und weist auf einer oberen Stirnseite eine Isolierung 20 auf, die einen Wärmeabfluß von den Gehäuseteilen 2, 3 zu dem Boden 19 verhindern soll.

Das Fördergut ist als ein in Gurtform vorliegendes Trägerelement mit einer Vielzahl von Chips für die Herstellung von Chipkarten ausgebildet, wobei vor dem Eintritt in den Ofen 1 die Chips jeweils mit einer zähflüssigen Vergußmasse auf der Rückseite vorgesehen sind. Diese Vergußmasse dient zur Abdeckung und Schutz des durch Bondtechnik an dafür vorgesehene Kontaktstellen des Trägerelements angeschlossene Chips.

Durch die Erwärmung der Vergußmasse in dem Ofen härtet diese aus, um dann nach Kühlung zur Implantation in einer Ausnehmung eines nicht dargestellten Kartenkörpers weiteren Prozeßschritten zugeführt zu werden.

Falls das Förderband 10 gewollt oder nicht gewollt gestoppt wird, ermöglicht ein längsverschiebbarer Stempel 21, daß die Gehäuseteile 2 und 3 in Querrichtung zu ihrer Längsachsen auseinander bewegt werden. Zu diesem Zweck weist das untere Gehäuseteil 3 eine langlochartige Ausnehmung 22 auf, durch die der Stempel 21 führbar ist. Alternativ ist es ausreichend, daß nur ein Gehäuseteil 2 in Querrichtung, und zwar nach oben hin, verschoben wird.

Eine Aufnahme 27 des oberen Gehäuseteils 2 dient zur Führung des Stempels 21 beim Auseinanderbewegen der Gehäuseteile 2, 3.

Die Aufheizung der vorzugsweise aus Aluminium bestehenden Gehäuseteile 2, 3 erfolgt unter Mitwirkung eines Heizregelgeräts, das mindestens einen PID-Regler aufweist, der eine Regelung der Temperatur der Heizpatronen einzeln oder in Gruppen ermöglicht. Zu diesem Zweck sind Heizfühler entlang des Gehäuseteils 2, 3 verteilt angeordnet, die eine Ist-Temperatur der Regeleinheit bereitstellen. Auf diese Weise wird das Bereitstellen unterschiedlicher Temperaturzonen entlang des Ofens 1 ermöglicht, so daß ein an die Erfordernisse des Fördergutes angepaßter Temperaturverlauf einstellbar ist.

Darüber hinaus kann der nicht dargestellte Antrieb des Förderbandes 10 regelbar ausgebildet sein, so daß die Bandgeschwindigkeit an die Heizleistung der Gehäuseteile 2, 3 angepaßt werden kann.

Um eine gleichmäßige Erwärmung des Förderguts zu gewährleisten, sind die Gehäuseteile 2, 3 jeweils mit einer oberen Abdeckung 23 und/oder einer unteren Abdeckung versehen. Die Abdeckung 23, 24 ist als Blech ausgebildet und über Bolzen 25 mit dem Ofen 1 verbunden.

## Patentansprüche

1. Ofen zum Erwärmen eines mit einem elektronischen Bauelement versehenen Trägerelements, insbesondere zum Aushärten von einer auf einen mit einem Chip versehenen Chipträger aufgebrachten Abdeckmasse,
- mit einem Gehäuse mit einer Eingangsöffnung und einer Ausgangsöffnung für die auf einem vorgegebenen Weg geführten Trägerelement und
- mit Mitteln zum Heizen zur Erzeugung einer vorgegebenen Heiztemperatur innerhalb des Gehäuses,
dadurch gekennzeichnet,
- daß ein oberes Gehäuseteil (2) und ein unteres Gehäuseteil (3) vorgesehen sind, die jeweils aus einem wärmeleitenden Material bestehen,
- daß mindestens ein Gehäuseteil (2) in Querrichtung bezogen auf die Ofenachse verschiebbar gelagert ist, wobei mindestens ein Gehäuseteil (2, 3) in einem mittleren Bereich eine Ausnehmung (4, 5) aufweist, so daß die Gehäuseteile (2, 3) in der Betriebposition unter Bildung eines Heizspaltes (4, 5) voneinander beabstandet sind, und
- daß ein Fördermittel (10) vorgesehen ist zum Transport der Trägerelement von der Eingangsöffnung (16) zu der Ausgangsöffnung (17).

2. Ofen nach Anspruch 1, dadurch gekennzeichnet, daß die Gehäuseteile (2, 3) jeweils eine Mehrzahl von Öffnungen (13) aufweisen, in denen die Mittel zum Heizen (14) einsteckbar sind

3. Ofen nach Anspruch 1 oder 2, dadurch gekennzeichnet, daß sich die Ausnehmung (4, 5) kanalförmig von einem stirnseitigen Ende (6, 8) bis zu einem gegenüberliegenden stirnseitigen Ende (7, 9) des Gehäuseteils (2, 3) erstreckt.

4. Ofen nach einem der Ansprüche 1 bis 3, dadurch gekennzeichnet, daß das obere und untere Gehäuseteil (2, 3) in einem in Querrichtung zu der Ausnehmung (4, 5) angrenzenden äußeren Bereich flächig ausgebildet sind und in der Betriebsposition flächig aneinander liegen.

5. Ofen nach einem der Ansprüche 1 bis 4, dadurch gekennzeichnet, daß sich die Öffnung (13) durchgehend von einer Seitenwand (11, 12) des Gehäuseteils (2, 3) bis zu einer gegenüberliegenden Seitenwand (11, 12) erstreckt und daß das Mittel zum Heizen als Heizpatrone (14) ausgebildet ist.

6. Ofen nach einem der Ansprüche 1 bis 5, dadurch gekennzeichnet, daß das untere Gehäuseteil (3) auf einer dem oberen Gehäuseteil (4) abgewandten Unterseite mit einem Träger (18) verbunden ist, der das untere Gehäuseteil (3) beabstandet von einem Boden (19) hält.

7. Ofen nach einem der Ansprüche 1 bis 6, dadurch gekennzeichnet, daß der Träger (18) als T-förmiger Träger ausgebildet ist.

8. Ofen nach einem der Ansprüche 1 bis 7, dadurch gekennzeichnet, daß der Träger (18) auf einer dem unteren Gehäuseteil (3) zugewandten Ende eine Isolierschicht (20) aufweist.

9. Ofen nach einem der Ansprüche 1 bis 8, dadurch gekennzeichnet, daß das untere Gehäuseteil (3) eine sich senkrecht zur Längserstreckung der Ausnehmung (4, 5) verlaufende Durchgangsbohrung (22) aufweist, durch die ein Stempel (21) führbar ist zur Positionierung des oberen Gehäuseteils (2) in Bezug auf das untere Gehäuseteil (3).

10. Ofen nach einem der Ansprüche 1 bis 9, dadurch gekennzeichnet, daß das obere Gehäuseteil (2) auf einer Unterseite desselben eine Aufnahme (27) aufweist, die zu der Durchgangsbohrung (22) des unteren Gehäuseteils (3) fluchtet, zur Aufnahme eines Endes des Stempels (21).

11. Ofen nach einem der Ansprüche 1 bis 10, dadurch gekennzeichnet, daß das obere Gehäuseteil (2) und das untere Gehäuseteil (3) jeweils auf einer dem benachbarten Gehäuseteil abgewandten Seite mit einer wärmeleitenden Abdeckung (23) versehen sind.

12. Ofen nach einem der Ansprüche 1 bis 11, dadurch gekennzeichnet, daß das obere Gehäuseteil (2) und das untere Gehäuseteil (3) aus einem Aluminium-Werkstoff bestehen.

13. Ofen nach einem der Ansprüche 1 bis 12, dadurch gekennzeichnet, daß das Mittel zum Heizen (14) mit einer Regeleinheit verbunden ist, so daß das Mittel (14) auf eine vorgegebene Temperatur regelbar ist.

14. Ofen nach einem der Ansprüche 1 bis 13, dadurch gekennzeichnet, daß entlang des oberen und/oder unteren Gehäuseteils (2, 3) mehrere Heizfühler verteilt angeordnet sind, die mit dem Regelgerät verbindbar sind, derart, daß in Förderrichtung mehrere Temperaturzonen bildbar sind.

15. Ofen nach einem der Ansprüche 1 bis 14, dadurch gekennzeichnet, daß das Fördermittel (10) mit einer regelbaren Antriebseinheit verbindbar ist.

16. Verfahren zum Aushärten von einer auf einen mit einem Chip versehenen Chipträger aufgebrachten Abdeckmasse, dadurch gekennzeichnet, daß der Chipträger kontinuierlich durch einen Ofen (1) auf einem in einer Förderebene liegenden Förderband (10) gefördert wird, wobei der Chipträger unter Bildung eines Heizspaltes von wärmeleitenden Gehäuseteilen (2, 3) des Ofens (1) umgeben ist.

17. Verfahren nach Anspruch 16, dadurch gekennzeichnet, daß in Abhängigkeit von der Bandgeschwindigkeit des Förderbandes und/oder eines Temperatur-Istwertes des Gehäuseteils (2, 3) der Abstand mindestens eines Gehäuseteils (2) zu einem gegenüberliegenden Gehäuseteil (3) durch ein Stellmittel (21) verstellt wird.
